(19) Europäisches Patentamt
European Patent Office
Office européen des brevets

(11) **EP 2 133 806 A1**

(12) **EUROPEAN PATENT APPLICATION**

(43) Date of publication:
**16.12.2009 Bulletin 2009/51**

(51) Int Cl.:
***G06F 17/50*** (2006.01)

(21) Application number: **08158055.7**

(22) Date of filing: **11.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **X-FAB Semiconductor Foundries AG 99097 Erfurt (DE)**

(72) Inventors:
• **Novoseltseva, Irina**
  **394030 Voronezh (RU)**
• **Fleischmann, Gehard**
  **99097 Erfurt (DE)**

(74) Representative: **Leonhard, Frank Reimund**
  **Leonhard - Olgemöller - Fricke**
  **Patentanwälte**
  **Postfach 10 09 62**
  **80083 München (DE)**

(54) **Transistor sizing method for combinatory standard cells**

(57)    A transistor sizing method for CMOS combinatory standard cells is disclosed which results in the minimizing cell delays. The method optimizes not only the P-type to N-type transistors ratio in an individual cell, but also balances the transistor size of different cells. It optimizes the total set of CMOS cells of the standard cell library.

FIG. 1

## Description

The invention relates in general to standard CMOS cells development methods, aimed at the improvement of the particular parameters of said cells, viz. summary cell delay.

Standard cells are the pre-designed layouts of wired transistors, which perform the certain types of logical functions. Some manufacturers, including XFAB, develop the standard cell libraries containing many different types of CMOS cells. Combinatorial cells implement logic function of present signals only. Sequential cell operation depends both on present input signals and previous operations or states. These standard cells are further used by the design engineers for large integrated circuits designing in accordance with the specifications. The design engineers provide a functional or a behavioral simulation of the integrated circuit using the hardware description language. Moreover, the design engineer specifies the delay time, power consumption and other parameters which the designed IC should satisfy. This is also a duty of a design engineer to specify the standard cells library for a certain project. Said standard cells library should be designed in advance in accordance to the requirements of the selected technology applied in the manufacture of the IC's. The next step in the design process performed by a design engineer is to create the functionally equivalent description of a resulting IC's logics on a gate level defined as a netlist, applying synthesis tools. The elements of a netlist are the instances of standard CMOS cells selected by the design synthesis software in the standard cell library according to the specified functionality and speed requirements.

Place and route software tools provide the circuit layout as a combination of standard cells and their connection both by metal wiring and via contacts.

The specifications and electric parameters of the designed integrated circuit are obviously determined directly by the appropriate parameters of standard cells selected from the standard cells library, i.e., when said standard cells have been pre-optimized by operating speed then the project engineer will have the best of this parameters regarding the IC's final design.

It is well-known that each standard cell comprises both the P-type and N-type transistors. P-type transistors are as a rule weaker than those of N-type in the terms of their potential to charge the load capacitance in the circuit, due to their comparatively higher resistance. The drive strength of a P-type transistor can be increased by means of expanding its gate width. The same applies for an N-type transistor.

Two or more transistors can be serially connected in a cell to obtain the required logical function. Obviously, the gate width of said transistors should also be expanded.

There are various conventional approaches to the selection of transistor size in a standard cell. This relates both to the selection of a particular ratio of a P-type to N-type transistor width, as well as to the choice of each transistor's width for a specified set of serially connected transistors.

This is a well-known fact that when the resistance of both P-type and N-type transistors is balanced, then the rising propagation delay and falling propagation delay will be equal. Hence, these cells are called balanced. In this case the P-type transistor's width should be 2 to 3 times greater than that of an N-type transistor. Moreover, the width of serially connected transistors in standard cells usually grows proportionally to the number of transistors connected in series in said cell, for example, when compared to a single transistor, this width must be two times greater for 2 transistors, three times greater for 3 coupled transistors etc. As a result, the width of P-type transistors e.g. in a cell comprising three serially connected transistors shall be 6-9 times greater than the minimum N-type transistor width.

Actually, the balanced standard cells libraries are not optimized by the cell delays, which correspond to an area occupied by these cells. On the one hand, P-type transistors function as drivers in a cell, and it is therefore quite reasonable to expand their width to make their conductivity equal or at least as close to that of N-type transistors as possible. However, on the other hand, this standard cell functions as a load for a cell in a previous circuit stage and any attempt to increase the width of its P-type transistors results in greater input capacitance of this cell. Whereas the propagation delay depends both on the conductivity of the standard cell transistors and on cell load capacitance, then any increase of P-type transistors width does not only reduce the charge time of said load capacitance by said P-type transistors but also causes the time required for the charge of an input capacitance of the discussed cell by the cell of a previous stage to increase. To eliminate this controversy, i.e., to obtain the optimum P-type to N-type transistors width ratio in a cell, the appropriate cell size selection method was proposed in US-A 6,477,695 "Methods for designing standard cell transistor structures", June 22, 1999.

The method includes generating a plurality of ratios between the P-type transistor and the N-type transistor, such that each of the plurality of ratios are derived by dividing a P-type gate width of the P-type transistor by an N-type gate width of the N-type transistor. Then, a plurality of average delays is generated for the transistor structure of the standard cell.

The average delay is essentially a delay value that is calculated by measuring the total serial delay that a chain of standard cells would see, if a plurality of identical standard cells with identical capacitance loads were connected in series, and then dividing by the number of identical cells being driven. Each of the generated plurality of average delays is associated with a corresponding one of the plurality of ratios. The method then proceeds to identify an optimum ratio from the plurality of ratios by finding a low one of the plurality of average delays. The low one of the plurality of average delays is used to size the P-type gate width of the P-type transistor and the N-type gate width of the N-type transistor, to obtain the most optimum reduced delay for a given standard cell design.

This method is based on the minimizing of propagation delays in identical serially connected standard cells, therefore the propagation delay depends in this case not only on drive strength of a transistor, but also on its input capacitance too. As a result, the width ratio of P-type to N-type transistors in the inverter circuit have been improved to a value of 1,3 compared to that of 2 to 3 in a balanced inverter. This provides the optimum width ratio of P-type to N-type transistors for each cell type.

The disadvantage of the proposed method is its extreme complexity whereas it requires individual modeling of each cell comprising the differing with ratios of P-type and N-type transistors width. When the standard cell library includes a set of 400 to 600 cells, enormously large number of modeling operations would be required, if the HSPICE from AVANT! or other applicable simulating software is used.

Another limitation of the above mentioned patented method is that it does not comprise any means for determining of an optimum transistor to transistor size ratio in different cells still belonging to the same standard cell library. This problem of determining the optimum P-type and N-type transistors size ratios in different cells is similar to that of an optimizing the size ratio of P-type and N-type transistors within the same standard cell. As soon as a number of N-type transistors of the same standard cell are connected serially, then the width of each of these transistors should be increased by the corresponding number of a transistor, to restore the drive force of a cell. But as soon as this width grows, the input capacitance of corresponding transistors goes up accordingly, thus the complete and total recovery of the drive strength does not make any sense.

In view of the foregoing, it is **an object of the present invention** to provide a simple, adequate and precise method for calculation of transistors size in standard cells which does not require abundant simulations and according to which the standard cells delay can be minimized without increasing area occupied by standard cell library, wherein said method comprising the optimum choice of transistor size ratios both within an individual standard cell and in different cells.

This object is solved by the method of claim 1. According to an aspect of the claimed invention, in order to achieve the above mentioned object, there is provided a transistor sizing method for CMOS combinatory standard cells which comprises the steps of

a) defining a model of a P-type transistor and N-type transistor;

b) defining a basic gate width of an N-type transistor in an elementary inverter circuit being an element of a standard cell library;

c) defining a first coefficient which is the ratio of an effective resistance of a P-type transistor to an effective resistance of an N-type transistor;

d) defining both the serial resistance coefficients (the reference signs are Ap_2, Ap_3,...,Ap_Np) for the at least two P-type transistors connected in series, and the serial resistance coefficients (the reference signs are An_2, An_3,...,An_Nn) for the at least two N-type transistors connected in series. There may be at least three or even more transistors of each type (P-type and N-type transistors). The amount of the respective transistor is Nn for N-type and Np for P-type, so mathematically the numbers are
Nn $\geq$ 2 or 3 and
Np $\geq$ 2 or 3.

e) defining the transistors structure of the standard cell according to its logical function;

f) determining the number of serially connected P-type transistors for each path from power supply node to a standard cell output and N-type transistors for each path from ground node to the standard cell output;

g) performing calculation of P-type transistor sizes for each selected path from the power supply node to the standard cell output using the formula

$$Wp = W \cdot \sqrt{\mu \cdot Ap\_Np}$$

where
W is a gate width of an N-type transistor in the elementary inverter cell,
Ap_Np is the serially connected transistors coefficient for the Np value of serially connected P-type transistors,
$\mu$ is the first coefficient comprising the value of a P-type transistor effective resistance to N-type transistor effective resistance ratio;

h) performing a calculation of N-type transistors size for the specified path from the ground node to the standard cell output using the formula

$$Wn = W \cdot \sqrt{An\_Nn}$$

wherein
W is a gate width of an N-type transistor in the elementary inverter cell,
An_Nn is the serially connected transistors coefficient for the Nn value of serially connected N-type transistors,

It is to mention that the model of a transistor determines the behaviour of a P-type transistor and N-type transistor elements of a logic circuit in silicon.

A first coefficient called $\mu$ and comprising the value of a P-type transistor effective resistance to N-type transistor effective resistance ratio can be determined as follows. A plurality of elementary relationships can be generated between the P-type transistor and N-type transistor in the elementary inverter circuit, wherein each of these relations is obtained by means of division of the gate width value of a P-type transistor by the gate width value of an N-type transistor. After that a plurality of rising propagation delays and falling propagation delays can be generated for the inverter circuit, wherein each of these propagation delays is associated with the corresponding of P-type transistor to N-type transistor ratio. Finally, the $\mu$ coefficient can be derived as a relation of a plurality of P-type transistor to N-type transistor ratios which correspond to the equality of rising propagation delay and falling propagation delay.

The (second or serial) coefficients Ap_2, Ap_3, ... , Ap_Np and An_2, An_3,..., An_Nn specify the rate by which the transistor gate width shall be increased in the combination of the amount Np or Nn of transistors connected in series, to provide their total effective resistance to be equal to the resistance of a single transistor.

Preferably, the (serial) coefficient Ap_Np for the number Np of serially connected P-type transistors is obtained as follows: generating a plurality of ratios for number Np of serially connected P-type transistors and a single P-type transistor, each of them being derived from the division of gate width values of serially connected P-type transistors by the gate width of a single P-type transistor; determining the charge time of a load capacitance via a single P-type transistor; generating a plurality of load capacitance charge times via serially connected transistors, wherein each of said charge times is associated with its corresponding serially connected transistors to a single transistor ratio; and determining the (second, serial) coefficient Ap_Np as the ratio from the plurality of serially connected P-type transistors to a single transistor ratio which corresponds to equality of the load capacitance charge time via the serially connected P-type transistors and via the single P-type transistor.

Preferably, the (serial) coefficient An_Nn for the Nn serially connected N-type transistors is obtained as follows: generating a plurality of ratios for Nn serially connected N-type transistors and a single N-type transistor, wherein each of them being derived from the division of gate width values of serially connected N-type transistors by the gate width of a single N-type transistor; determining the discharge time of a load capacitance via a single N-type transistor; generating a plurality of load capacitance discharge times via serially connected transistors, wherein each of said discharge times is associated with its corresponding serially connected transistors to a single transistor ratio; and determining the An_Nn coefficient as the ratio from the plurality of serially connected N-type transistors to a single transistor ratio which corresponds to equality of the load capacitance discharge time via the serially connected N-type transistors and via the single N-type transistor.

Preferably, the serial coefficients Ap_1 and An_1 for a single transistor are equal to one.

The advantages and effect of this invention is the optimum method for the defining of P-type to N-type transistors ratio within a single standard cell, and obtaining the ratio of transistor sizes in different standard cells. The results of this optimization are the reduced summary cell delays in combinatorial standard cells without deterioration of their summary area, which results in the design of fast integrated circuits based on standard cells. The expected decrease of cell delay in comparison with that of standard cell optimized by the prior art method as described in the US-A 6,477,695 is about 10%.

Secondly, this method is rather simple requiring far less hardware and software resources for standard cells modeling and circuit simulation, which in turn saves the time required for standard cell library design.

Advantageous embodiments may be taken from the dependent claims.

Further features, characteristics and advantages of the invention may be taken from the following detailed description of embodiments of the present invention when the same is read in connection with the accompanying drawings. It should be expressly understood, however, that the drawings are for purpose of illustration only and are not intended as a definition of the limits of the invention.

In the drawings ...

Fig.1 is a flowchart identifying operations for optimizing the transistor width of standard cells belonging to the same library;

Fig.2 shows current-voltage curve of N-type transistor;

Fig.3A shows simulation circuit for defining of serially connected coefficient of P-type transistors;

Fig.3B shows simulation circuit for defining of serially connected coefficient of N-type transistors;

Fig.4 illustrates defining of optimum P-type and N-type transistor ratio by the example of 2 3-AND into 2-NOR standard cell;

Fig.5 is an example of serial connected cells of different types for deriving of optimal transistor ratio of different cells.

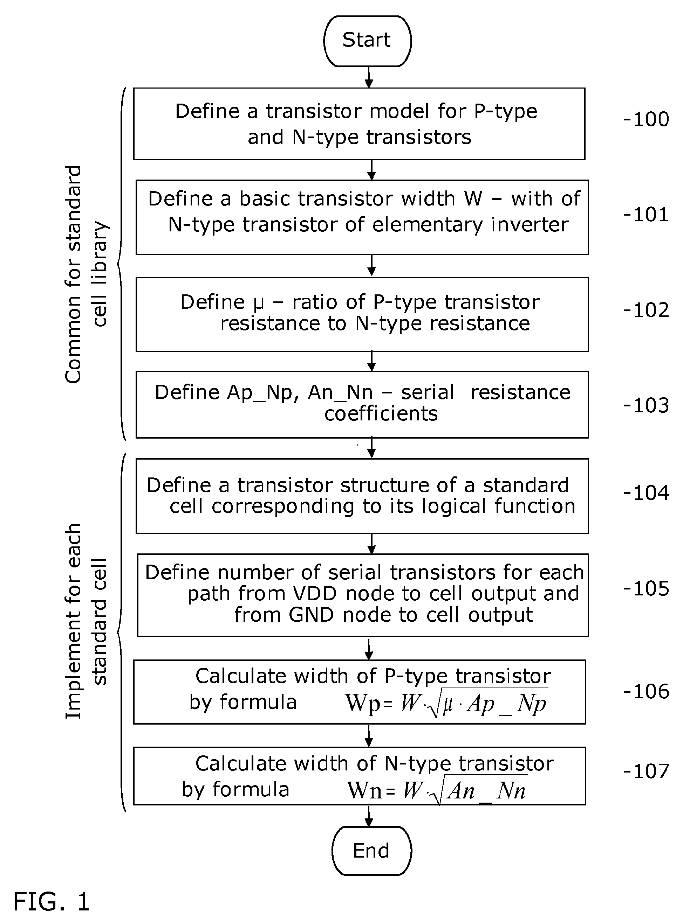

FIG. 1 is a flowchart of the optimization method for the transistors comprising the standard cells of combinatory type being the components to the same standard cell library.

Certain operations for the transistor width optimization in standard cells shall be performed only once for the particular process of manufacture and selected standard cell library. They are: P-type and N-type transistor models designated as 100 in the flowchart; defining of the N-type transistor gate width in the elementary inverter circuit, designated as 101; defining of $\mu$ coefficients as 102; defining of Ap_Np, An_Nn values as 103.

All other operations, namely, the defining of the standard cell transistor structure, designated 104, determining of a number of serially connected P-type and N-type transistors for each path from supply voltage node or ground node to standard cell output, designated 105, and the calculation of the optimum width for both P-type and N-type transistors, shown as 106, 107 are repeated for each standard cell in the selected standard cell library.

The defining of N-type transistor gate width in the elementary inverter circuit 101 depends on both the applied technology process and the field of a standard cell library application, i.e., on the expected speed in terms of propagation delay and the expected power consumption of a final circuit. For a standard cell library with low power consumption the minimum possible transistor width complying with the applied design rules shall be recommended. For a high-speed standard cell library the N-type transistor width in the elementary inverter cell should be increased significantly. In this case the charging of parasitic capacitances of wiring in the standard cell circuit design takes less time thus, increasing the final circuit speed.

The coefficient $\mu$ shown as 102 is actually the value of a P-type transistor effective resistance to N-type transistor effective resistance ratio. This effective resistance of a P-type transistor is greater than that of N-type transistor. Assuming that $\mu$ is the ratio of a P-type transistor effective resistance to N-type transistor effective resistance, it is apparent that said effective resistance of P-type transistor is greater than the effective resistance of N-type transistor by the factor of $\mu$. Here the term of effective resistance is used for reason that the actual resistance of a transistor depends on both its source and drain voltages, but only the resulting effect of the resistance of the transistor is significant in the invented method manifesting itself in the charging and discharge times of a load capacitance.

The value of $\mu$ coefficient can be determined by the selected process, remaining in the range from 2 to 3. If both transistors in the elementary inverter cell have the same width, then the rising propagation delay shall be greater than falling propagation delay. Now a plurality of ratios between P-type transistor and N-type transistor is generated. Each of these ratios can be obtained from the division of P-type transistor gate width by the N-type transistor gate width.

Then, applying the appropriate simulation software, the plurality of rising propagation delays and falling propagation delays for the inverter cell loaded with a some capacitor are generated, each of these propagation delays is associated with the corresponding ratio between the P-type and N-type of the transistors.

Then the $\mu$ coefficient as one particular ratio of the whole plurality of P-type to N-type transistor ratios is specified which in turn corresponds to the condition when rising propagation delays and falling propagation delays are equal to each other.

This condition of rising propagation delays and falling propagation delays equality means that the effective resistance of P-type transistor is equal to that of N-type transistor. Whereas the resistance of a transistor is an inverse to its physical width, we assume now that for P-type and N-type transistors having the same width the resistance of P-type transistor is greater than the resistance of N-type transistors by factor of $\mu$.

The coefficients 103 of Ap_Np, An_Nn which characterize the serially connected resistances indicate the actual multiplication factor for the width of Np or Nn serially connected transistors which is required to obtain the resulting drive strength equal to the drive strength of a single transistor.

To obtain the required logical function of a standard cell its P-type and N-type transistors can be connected in series, for example, as a pair of N-type transistors on the NAND 2 cell, or a pair of P-type transistors in the NOR 2 cell. Compliant to the Ohm's Law, the width of two serially connected transistors should be extended by factor of 2, to obtain the resulting total resistance equal to that of a single transistor.

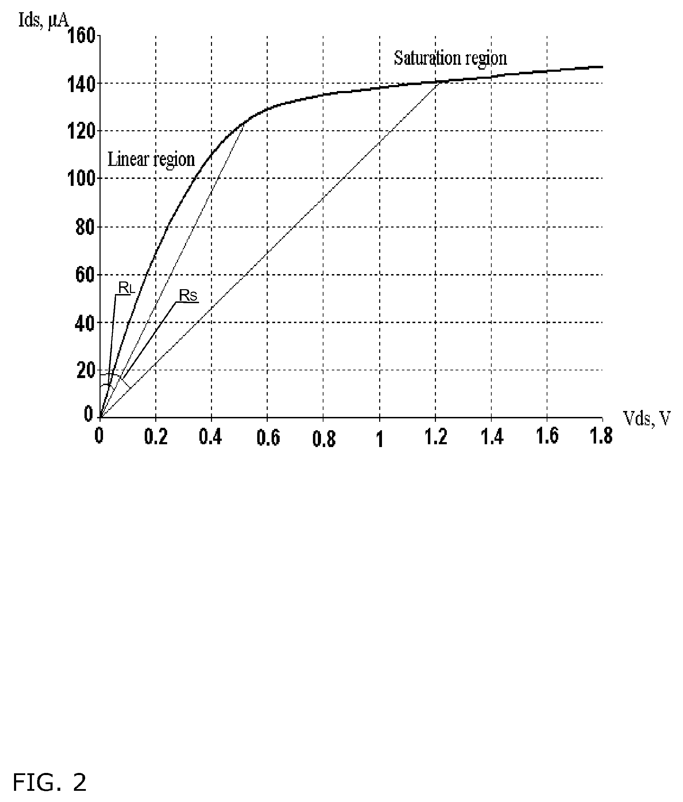

However, the actual effective resistance of two or more transistors connected in series is not equal to a sum of effective resistance values of each transistor in this circuit. The explanation of this effect is that the characteristics of a transistor are not linear. FIG.2 shows the effect of N-type transistor source-to-drain voltage on drain current.

The effective resistance of any transistor in any point of its current-voltage curve is actually the relation of its source voltage to source current or the tangent of the angle corresponding to it. This resistance RI in the linear region of the current-voltage curve of a transistor is less than the resistance in the saturation region Rs. When two transistors are connected in series their supply voltage is shared by both of them and divided between them. Accordingly, the actual operating points of both transistors shift from saturation region to less resistive linear region of a current-voltage curve thus making a sum total of their effective resistance values less than the effective resistance of a single transistor structure having a width twice as large.

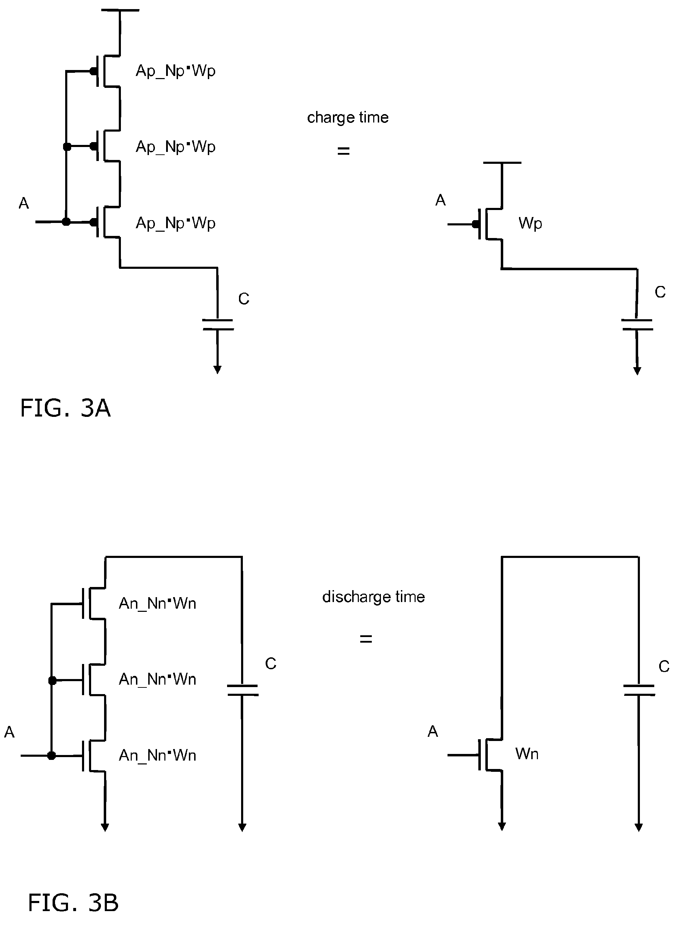

Further, the Ap_Np value for the Np serially connected P-type transistors is calculated. A plurality of ratios for Np serially connected P-type transistors and a single P-type transistor is generated, wherein each such ratio can be derived from the division of a gate width of serially connected P-type transistors by the gate width of a single P-type transistor. Then, the load capacitor charge time can be calculated via a single P-type transistor. After that, a plurality of load capacitor charge time can be calculated via an Np of serially connected P-type transistors, each of these charge times can be associated with its corresponding ratios of serially connected P-type transistors to a single P-type transistor. The simulation circuits are shown in FIG. 3A. The Ap_Np coefficients are specified as a particular value chosen from all plurality of serially connected P-type transistors to a single P-type transistor ratios, said particular value is characterized by the condition when load capacitor charge time via Np serially connected transistors and load capacitor charge time via a single P-type transistor are equal.

Similar coefficients for N-type transistors are obtained in the same way, the only difference is that the load capacitance discharge times are compared for a single transistor and the combination of Nn serially connected N-type transistors instead of their charge times, as shown in FIG.3B.

As a rule, 2 to 4 serially connected transistors are used in the design of a standard cell library, therefore the most frequently used coefficients Ap_2, Ap_3, Ap_4, An_2, An_3, An_4 should be calculated for further use as constants for particular technology. The values of Ap_Np, An_Nn usually differ from a number of serially connected transistors in a standard cell, for example, the value of An_2 for two serially connected transistors can be 1.7, which means that the transistors width should be extended by factor of 1.7 instead of 2. The driver strength composed of two serially connected transistors can be thus equal to a drive strength of a single transistor.

Going back to a flowchart of optimization shown in FIG. 1, the next operation is designated 104, as the defining of a standard cell transistor structure. The transistor structure should comply with logical function performed by standard cell. According to this logical function, a standard cell may have several branches comprising a different number of serially connected P-type transistors or N-type transistors. As shown at 105 of the flowchart, the number of serially connected transistors Np, Nn is specified for each path from the supply voltage node to standard cell output and from ground node to standard cell output. The concluding operations shown as 106, 107 in the flowchart provide the solution for calculating the optimum transistor sizes for any combinatorial type standard cell by means of simple versatile formulas. Optimum sizes of P-type and N-type transistors in standard cells of various types depend ultimately on the Ap_Np, An_Nn coefficients for serially connected transistors, which means that said transistor sizes depend only on a number of transistors in the path from power node or ground node to standard cell output, respectively.

The backgrounds of formulas used in practical calculations are shown below.

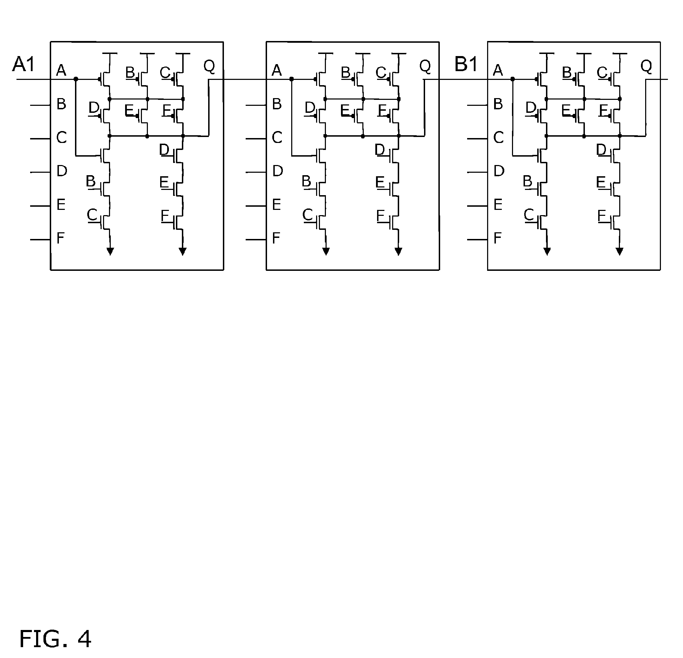

The cell structure is disclosed containing the P-type and N-type transistors connected in series and in parallel. FIG.4 is an example of a 2 3-AND into 2-NOR standard cell loaded with the same standard cell. The cell 2 3-AND into 2-NOR has two serially connected P-type transistors and three serially connected N-type transistors. In general embodiment the total number of P-type transistors in serial connection is Np, whereas the number of N-type transistors connected in series is Nn.

For the selection of optimum ratios the worst possible case regarding the circuit speed is analyzed when the charge or discharging at the Q output of the analyzed standard cell occurs via a single path, shaped as one of several parallel branches containing of a series of transistors. In other words, when the output Q is switched to high logical level, the input capacitor is charged through a series Np of P-type transistors, and when it is switched to lower level, the output is discharged through a series Nn of N-type transistors.

Further, the propagation delay between the nodes A1 and B1 is calculated, i.e., over the path containing two standard cells, which is necessary to specify the P-type to N-type transistor size ratio at which the propagation delay is at its minimum. Assuming that when the output of the first standard cell switches to high level, the output of the another standard cell is simultaneously switched to low level, then the total propagation delay of both standard cells is

$$T_{sum} = T_{rise} + T_{fall}$$

where:

$T_{rise}$ is the rising propagation delay
$T_{fall}$ is the falling propagation delay.

It means that the criterion of the minimum propagation delay over two standard cells can be formulated as a sum total of two delays, one of which corresponds to the rising propagation delay and the other one to the falling propagation delay.
Assuming now that the width of P-type transistors is greater than the width of the N-type transistors by a factor of K. Let the total normalized width of both transistors is 1 and the normalized total gate capacitance of two gates of both transistors is also 1. The constant total width of the transistors means that we change only the relative value of transistors sizes without any changes of their total area occupied by these transistors on a chip.
The normalized width of N-type and P-type transistors can be expressed as

$$Wn = \frac{1}{1+K}, \quad Wp = \frac{K}{1+K}$$

Whereas the gate capacitance of a transistor is proportional to its width then the normalized gate capacitances of N-type and P-type transistors, respectively, will be

$$Cn = \frac{1}{1+K}, \quad Cp = \frac{K}{1+K}$$

The effective resistance of a transistor is inverse to its width, moreover, the resistance of a P -type transistor should be multiplied by factor $\mu$. Accordingly the normalized resistance values can be expressed as

$$Rn = 1+K \quad Rp = \frac{\mu \cdot (1+K)}{K}$$

Finally we use the time constant $_T$=R*C = (little 'tau') for evaluation purpose of the propagation delay. The resistance of the complete path of serially connected N-type transistors increases by factor of An_Nn, the resistance of a P-type transistors series is increased by factor of Ap_Np, respectively.
Then the total rise and fall propagation delay is

$$Tsum = (An\_Nn \cdot Rn + Ap\_Np \cdot Rp) \cdot (Cn + Cp) = \frac{Ap\_Np \cdot \mu \cdot (1+K)}{K} + An\_Nn \cdot (1+K)$$

To obtain the correct value of K which is responsible for minimum obtainable propagation delay the derivative of the $T_{sun}$, function by K must be equal to zero.

The solution of said equation is

$$K = \sqrt{\frac{\mu \cdot Ap\_Np}{An\_Nn}} \qquad\qquad [1]$$

Here, the formula is derived, disclosing the optimum P-type and N-type transistors size ratio for each combinatorial standard cell. Still it is necessary for the design of a standard cells library to define how the transistor sizes in different standard cells must be related to each other.

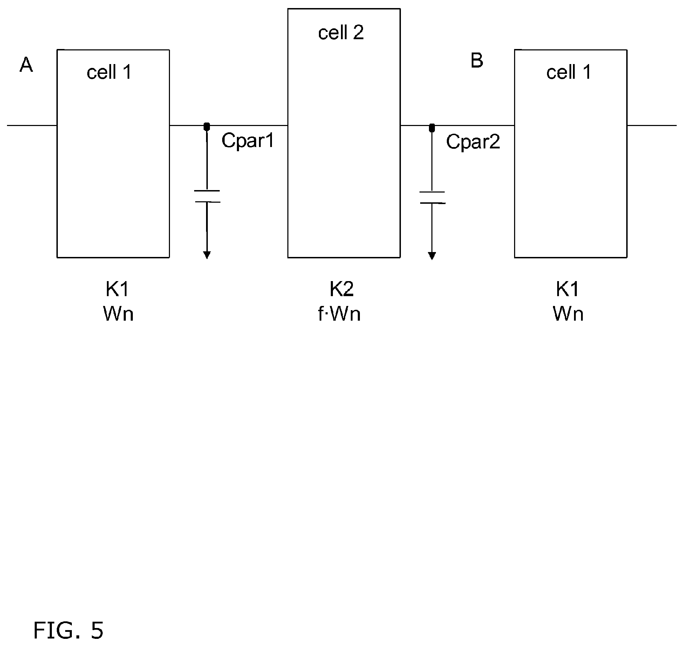

Further, two different standard cells are analyzed and optimum ratio of their sizes is calculated. These standard cells are shown in FIG.5. The number of P-type and N-type transistors connected in series in standard cell 1 is Np1, Nn1, respectively, whereas the same data for standard cell 2 is Np2, Nn2, respectively.

Standard cell 1 output is loaded with standard cell 2, while the load at the output of standard cell 2 is the standard cell 1. The parasitic capacitance of connecting wire Cpar1 is also present at the standard cell 1 output, while similar parasitic capacitance Cpar2 is connected to standard cell 2 output. Output fan-outs for both standard cells are assumed to be 1 because the averaged fan-out in most different projects will be the same for all outputs, thus the fan-out values would not affect the final analysis results.

Optimum P-type transistors to N-type transistors size ratio is K1 for standard cell 1 and K2 for standard cell 2. Let the N-type transistor of standard cell 2 be larger than N-type transistor in standard cell 1 by factor of f. Total gate capacitance of two P-type transistors and two N-type transistors in both standard cells is 1.

The resulting parameters of the transistors in two standard cells are shown in the table below (on next page).

**Table 1.**

| Parameters of the transistors in two standard cells | | | |
|---|---|---|---|
| | Transistor (conductivity) type | Rated gate capacitance value | Rated resistance value |
| Standard cell 1 | P | $\dfrac{K1}{1+K1+f+f\cdot K2}$ | $\dfrac{\mu\cdot(1+K1+f+f\cdot K2)}{K1}$ |
| | N | $\dfrac{1}{1+K1+f+f\cdot K2}$ | $1+K1+f+f\cdot K2$ |
| Standard cell 2 | P | $\dfrac{f\cdot K2}{1+K1+f+f\cdot K2}$ | $\dfrac{\mu\cdot(1+K1+f+f\cdot K2)}{f\cdot K1}$ |
| | N | $\dfrac{f}{1+K1+f+f\cdot K2}$ | $\dfrac{1+K1+f+f\cdot K2}{f}$ |

The criterion of optimal cell design is the minimum total rise and fall propagation delay in two standard cells, i.e., between the A and B nodes in FIG. 5, as shown below.

$$Tsum = (An\_Nn1\cdot Rn1 + Ap\_Np1\cdot Rp1)\cdot(Cn2 + Cp2 + Cpar1)$$
$$+ (An\_Nn2\cdot Rn2 + Ap\_Np2\cdot Rp2)\cdot(Cn1 + Cp1 + Cpar2)$$

By substituting the terms in this formula with the parameters of the transistors and subsequent grouping of terms, we obtain the resulting formula:

$$Tsum = (An\_Nn1 + \frac{\mu \cdot Ap\_Np1}{K1}) \cdot f \cdot (1 + K2) +$$

$$(1 + K1 + f + f \cdot K2) \cdot (An\_Nn1 + \frac{\mu \cdot Ap\_Np1}{K1}) \cdot Cpar2 +$$

$$(\frac{An\_Nn2}{f} + \frac{\mu \cdot Ap\_Np2}{K2 \cdot f}) \cdot f \cdot (1 + K1) + (1 + K1 + f + f \cdot K2) \cdot (\frac{An\_Nn2}{f} + \frac{\mu \cdot Ap\_Np2}{K2 \cdot f}) \cdot Cpar1$$

Here the condition of minimum propagation delay function is the following value of f:

$$f = \sqrt{\frac{(An\_Nn2 + \frac{\mu \cdot Ap\_Np2}{K2}) \cdot (1 + K1) \cdot (1 + Cpar2)}{(An\_Nn1 + \frac{\mu \cdot Ap\_Np1}{K1}) \cdot (1 + K2) \cdot (1 + Cpar1)}} \qquad [2]$$

In their practical application in various projects the analyzed standard cells may have the varying values of parasitic capacitance $C_{par1}$, $C_{par2}$ introduced by circuit's internal wiring connected to cell outputs. However, the averaged $C_{par1}$, $C_{par2}$ values, obtained from a great number of circuit designs may be very close to each other. If this parasitic capacitance data is averaged by numerous projects, it must be approximately the same in all of them, then the terms corresponding to these capacitance in formula [2] may be neglected and reduced.
After all these changes we have the next formula

$$f = \sqrt{\frac{(An\_Nn2 + \frac{\mu \cdot Ap\_Np2}{K2}) \cdot (1 + K1)}{(An\_Nn1 + \frac{\mu \cdot Ap\_Np1}{K1}) \cdot (1 + K2)}} \qquad [3]$$

By means of this formula the respective relative sizes of various standard cells combinations can be calculated. It should be mentioned here and again that the "size ratio f" to be applied for the evaluation of various standard cell combinations is actually the N-type transistors size ratio in respective standard cells.
When the relative size of each combinatory standard cell is calculated respective to inverter standard cell, the result will be the optimum related cell size values of all respective standard cells in the standard cell library.
Assuming that standard cell 1 in formula [3] is the inverter with coefficients

$$An\_1 = 1, \quad Ap\_1 = 1, \quad K1 = \sqrt{\mu}$$

and the standard cell 2 is an arbitrary element of the implemented standard cell library, after all conversions in the formula the arbitrary standard cell to inverter standard cell ratio is obtained, as shown here:

$$f = \sqrt{An\_Nn}$$

where $An\_Nn$ is a coefficient corresponding to Nn of N-type transistors connected in series.

Whereas the size ratio of standard cell combinations is limited by size ratios of N-type transistors of the respective standard cells, the width of N-type transistor in the respective standard cell may be expressed as:

$$Wn = W \cdot \sqrt{An\_Nn}$$

where

W        is a gate width of an N-type transistor in the elementary inverter cell,
An_Nn    is the serially connected transistors coefficient for the value Nn of serially connected N-type transistors.

Further, the P-type transistor width for all P-type transistors in an arbitrary standard cell path is obtained from power node to cell output relatively to the N-type transistor width in the elementary inverter cell. To do so, the N-type transistor width in a standard cell is multiplied by factor of K from the equation [1].

The result is:

$$Wp = W \cdot \sqrt{\mu \cdot Ap\_Np}$$

where:

W        is a gate width of N-type transistor in the elementary inverter cell,
Ap_Np    is the serially connected transistors coefficient for the Np value of serially connected P-type transistors,
$\mu$        is the coefficient comprising the value of a P-type transistor effective resistance to N-type transistor effective resistance ratio.

**Claims**

1.  **Method of Transistor sizing** for CMOS combinatory standard cells, comprising the following steps

    a) defining a model of a P-type transistor and N-type transistor;
    b) defining a basic gate width W of an N-type transistor in an elementary inverter circuit being an element of a standard cell library;
    c) defining a first coefficient ($\mu$) which is the ratio of an effective resistance of a P-type transistor to an effective resistance of an N-type transistor;
    d) defining both the serial resistance coefficients (Ap_2, Ap_3,...,Ap_Np) for the at least two or three (Np) P-type transistors connected in series, and the serial resistance coefficients (An_2, An_3,...,An_Nn) for the at least two or three (Nn) N-type transistors connected in series;
    e) defining the transistors structure of the standard cell according to its logical function;
    f) determining the number of serially connected P-type transistors (Np) for each path from power supply node to a standard cell output and N-type transistors (Nn) for each path from ground node to the standard cell output;
    g) performing calculation of P-type transistor sizes for each selected path from the power supply node to the standard cell output using formula

$$Wp = W \cdot \sqrt{\mu \cdot Ap\_Np} \quad ,$$

where:

W is a gate width of an N-type transistor in the elementary inverter cell,
Ap_Np is the serially connected transistors coefficient for the value (Np) of serially connected P-type transistors,
$\mu$ is the coefficient comprising the value of a P-type transistor effective resistance to N-type transistor effective resistance ratio;

h) performing calculation of N-type transistors size for the specified path from the ground node to the standard cell output using the formula

$$Wn = W \cdot \sqrt{An\_Nn}$$ ,

where:

W is a gate width of an N-type transistor in the elementary inverter cell,
An_Nn is the serially connected transistors coefficient for the value (Nn) of serially connected N-type transistors.

2. The method as claimed in claim 1, wherein the model of a transistor determines the behaviour of a P-type transistor and N-type transistor elements of a logic circuit in silicon.

3. The method as claimed in claim 1, wherein the first coefficient ($\mu$) is determined as follows:

- generating of a plurality of elementary relationships between the P-type transistor and N-type transistor in the elementary inverter circuit, wherein each of these relations is obtained by means of division of the gate width value of a P-type transistor by the gate width value of an N-type transistor;
- generating of a plurality of rising propagation delays and falling propagation delays for the inverter circuit, wherein each of these propagation delays is associated with the corresponding of P-type transistor to N-type transistor ratio; and
- deriving the first coefficient ($\mu$) as a relation of a plurality of P-type transistor to N-type transistor ratios which corresponds to the equality of rising propagation delay and falling propagation delay.

4. The method as claimed in one of the preceding claims, wherein the serial coefficients (Ap_2, Ap_3, ... , Ap_Np and An_2, An_3,..., An_Nn) specify the rate by which the transistor gate width shall be increased in the combination of transistors (Np or Nn) connected in series, to provide their total effective resistance to be equal to the resistance of a single transistor.

5. The method according to one of the preceding claims, wherein the serial coefficient (Ap_Np) for the number (Np) of serially connected P-type transistors is obtained as follows

- generating a plurality of ratios for the number (Np) serially connected P-type transistors and a single P-type transistor, each of them being derived from the division of gate width values of serially connected P-type transistors by the gate width of a single P-type transistor;
- determining the charge time of a load capacitance via a single P-type transistor;
- generating a plurality of load capacitance charge times via serially connected transistors, wherein each of said charge times is associated with its corresponding serially connected transistors to a single transistor ratio; and
- determining the serial coefficient (Ap_Np) as the ratio from the plurality of serially connected P-type transistors to a single transistor ratios which corresponds to equality of the load capacitance charge time via the serially connected P-type transistors and via the single P-type transistor.

6. The method according to one of the claims 1 to 4, wherein the serial coefficient (An_Nn) for the number (Nn) of serially connected N-type transistors is obtained as follows

- generating a plurality of ratios for number (Nn) of serially connected N-type transistors and a single N-type transistor, wherein each of them being derived from the division of gate width values of serially connected N-type transistors by the gate width of a single N-type transistor;
- determining the discharge time of a load capacitance via a single N-type transistor;
- generating a plurality of load capacitance discharge times via serially connected transistors, wherein each of said discharge times is associated with its corresponding serially connected transistors to a single transistor ratio; and
- determining the serial coefficient (An_Nn) as the ratio from the plurality of serially connected N-type transistors to a single transistor ratios which corresponds to equality of the load capacitance discharge time via the serially connected N-type transistors and via the single N-type transistor.

7. The method according to one of the preceding claims, **characterized in that** the serial coefficients (Ap_1 and An_1) for a single transistor are equal to 1 (one).

Start

Common for standard cell library

Define a transistor model for P-type and N-type transistors — -100

Define a basic transistor width W – with of N-type transistor of elementary inverter — -101

Define µ – ratio of P-type transistor resistance to N-type resistance — -102

Define Ap_Np, An_Nn – serial resistance coefficients — -103

Implement for each standard cell

Define a transistor structure of a standard cell corresponding to its logical function — -104

Define number of serial transistors for each path from VDD node to cell output and from GND node to cell output — -105

Calculate width of P-type transistor by formula $Wp = W \cdot \sqrt{\mu \cdot Ap\_Np}$ — -106

Calculate width of N-type transistor by formula $Wn = W \cdot \sqrt{An\_Nn}$ — -107

End

FIG. 1

FIG. 2

Ap_Np·Wp

Ap_Np·Wp

A

Ap_Np·Wp

C

charge time

=

A

Wp

C

FIG. 3A

An_Nn·Wn

An_Nn·Wn

C

A

An_Nn·Wn

discharge time

=

C

A

Wn

FIG. 3B

FIG. 4

FIG. 5

**EUROPEAN SEARCH REPORT**

Application Number

EP 08 15 8055

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SHAMS M ET AL: "Delay optimization of CMOS logic circuits using closed-form expressions" COMPUTER DESIGN, 1999. (ICCD '99). INTERNATIONAL CONFERENCE ON AUSTIN, TX, USA 10-13 OCT. 1999, LOS ALAMITOS, CA, USA,IEEE COMPUT. SOC, US, 10 October 1999 (1999-10-10), pages 563-568, XP010360536 ISBN: 978-0-7695-0406-3 * the whole document * | 1-7 | INV. G06F17/50 |
| A | US 6 316 301 B1 (KANT SHREE [US]) 13 November 2001 (2001-11-13) * abstract * * column 1 - column 3, line 10 * * column 4, line 20 - line 36 * | 1-7 | |

TECHNICAL FIELDS
SEARCHED (IPC)

G06F

The present search report has been drawn up for all claims

| Place of search | Date of completion of the search | Examiner |
|---|---|---|
| Munich | 14 October 2008 | Radev, Boyan |

EPO FORM 1503 03.82 (P04C01)

**ANNEX TO THE EUROPEAN SEARCH REPORT
ON EUROPEAN PATENT APPLICATION NO.**

EP 08 15 8055

This annex lists the patent family members relating to the patent documents cited in the above-mentioned European search report.
The members are as contained in the European Patent Office EDP file on
The European Patent Office is in no way liable for these particulars which are merely given for the purpose of information.

14-10-2008

| Patent document cited in search report | Publication date | Patent family member(s) | Publication date |
|---|---|---|---|
| US 6316301 B1 | 13-11-2001 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 6477695 A